# EUROPÄISCHE PATENTSCHRIFT

(11) **EP 1 649 736 B1**
(45) Veröffentlichungstag und Bekanntmachung des Hinweises auf die Patenterteilung: **09.03.2011**
(21) Anmeldenummer: 04738807.9
(22) Anmeldetag: 28.06.2004
(51) Int. Cl.: H01L 23/427, H05K 7/20

(54) **KÜHLVORRICHTUNG FÜR EIN ELEKTRONISCHES BAUELEMENT, INSBESONDERE FÜR EINEN MIKROPROZESSOR**
COOLING DEVICE FOR AN ELECTRONIC COMPONENT, ESPECIALLY FOR A MICROPROCESSOR
DISPOSITIF DE REFROIDISSEMENT D'UN COMPOSANT ELECTRONIQUE, EN PARTICULIER D'UN MICROPROCESSEUR

(30) Priorität: 30.07.2003 DE 10335197
(43) Veröffentlichungstag der Anmeldung: 26.04.2006
(73) Patentinhaber: Liebert Corporation, Columbus, OH 34085 (US)
(72) Erfinder: FONFARA, Harald, 94551 Lalling (DE); GÖSTL, Herbert, 94227 Zwiesel (DE); MILTKAU, Thorsten, 94469 Deggendorf (DE); EBERL, Markus, 94563 Otzing (DE); MOLLIK, Ralf, 94526 Metten (DE)
(74) Vertreter: Heim, Hans-Karl
(86) Internationale Anmeldenummer: PCT/DE2004/001361
(87) Internationale Veröffentlichungsnummer: WO 2005/015970

(56) Entgegenhaltungen:
- EP-A- 1 204 143
- WO-A-02/102124
- WO-A-03/007376
- US-A- 5 982 616
- US-A1- 2002 021 557
- PATENT ABSTRACTS OF JAPAN Bd. 0122, Nr. 50 (E-633), 14. Juli 1988 (1988-07-14) -& JP 63 038245 A (ISHIKAWAJIMA HARIMA HEAVY IND CO LTD), 18. Februar 1988 (1988-02-18)

## Beschreibung

Die Erfindung betrifft eine Kühlvorrichtung für ein elektronisches Bauelement, insbesondere für einen Mikroprozessor, mit den Merkmalen des Oberbegriffs des Patentanspruchs 1. Des Weiteren betrifft die Erfindung ein Rack zur Aufnahme von mehreren Elektronikkomponenten, wie Server für Datenverarbeitungsanlagen, mit den Merkmalen des Patentanspruchs 8.

In größeren elektronischen Datenverabeitungsanlagen werden die einzelnen Elektronikkomponenten, wie beispielsweise eine Mehrzahl von Servern, in Schränken oder Racks aufgenommen, um eine geordnete Aufstellung und Verkabelung der einzelnen Komponenten zu gewährleisten. Zudem erfolgt in Racks oder Schränken für derartige Elektronikkomponenten eine Klimatisierung, d.h. die von den Komponenten erzeugte Verlustleistung in Form von Wärmeenergie wird mit geeigneten Mitteln abgeführt. Im Folgenden wird der Begriff Rack sowohl für geschlossene Schränke als auch für offene Gestelle verwendet, in die die einzelnen Komponenten aufgenommen sind. Die Verlustleistung wird hauptsächlich von elektronischen Bauelementen der einzelnen Komponenten erzeugt. Bei modernen Datenverarbeitungsanlagen wird dabei der überwiegende Teil der Verlustleistung von Mikroprozessoren erzeugt. Die Verlustleistung eines Prozessors liegt bisher in der Größenordnung von ca. 100 W. Eine Verlustleistung in diesem Bereich wurde mit Prozessorlüftern, d.h. einer Kombination aus einem metallischen Kühlkörper und einem Lüfterbaustein, vom Prozessor in das Innere des Gehäuses des Servers bzw. der Elektronikkomponente, von dort in das Innere des (vorzugsweise geschlossenen) Racks und anschließend an die das Rack umgebende Raumluft abgeführt. Hinzu kommt die Verlustleistung in Form von Wärme, die von weiteren Baugruppen und Bauteilen der einzelnen Elektronikkomponenten, wie Netzteilen, Laufwerken etc., abgegeben wird, d.h. von einer Vielzahl von einzelnen elektronischen Bauelementen, die für sich genommen zwar eine relativ geringe Verlustleistung abgeben, so dass sich eine separate Kühlung dieser elektronischen Bauelemente nicht lohnt, wobei sich diese geringe Verlustleistungen jedoch auch auf Werte von 100 bis 150 W und mehr pro Elektronikkomponente aufsummieren können. Zusätzlich zu den Prozessorlüftern sind daher in der Regel zusätzliche Lüfter erforderlich, um die gesamte im Gehäuse der Elektronikkomponente erzeugte Verlustwärme aus diesem abzuführen. Bei Serverracks, die bis zu 50 einzelne Server mit ggf. jeweils mehreren Prozessoren aufnehmen können, ergibt sich somit pro Rack bereits jetzt eine Gesamtverlustleistung von 10 kW bis 12,5 kW.

Für kommende Generationen von Elektronikkomponenten wird eine Steigerung der von einzelnen elektronischen Bauelementen, wie Mikroprozessoren, abgegebenen Wärmeverlustleistung in Bereiche von 150 bis 200 W und mehr erwartet. Dies führt bei einem Rack mit beispielsweise bis zu 50 Servern einschließlich der zusätzlichen Verlustleistung von 100 bis 150 W pro Elektronikkomponente zu einer Gesamtverlustleistung von bis zu 17,5 kW und mehr pro Rack. Derart hohe Verlustleistungen in Form von Abwärme lassen sich allein durch das Wärmeträgermedium Luft nicht mehr mit vernünftigem Aufwand beherrschen.

Bei einzelnen Elektronikkomponenten, wie Servern, ist es bekannt, elektronische Bauelemente, insbesondere Mikroprozessoren, die für sich genommen eine hohe Verlustleistung erzeugen, anstatt mit Kombinationen von Kühlkörpern und Lüftern durch mit einem flüssigen Kühlmedium, beispielsweise Wasser, durchströmte Kühlkörper zu kühlen. Somit muss lediglich noch die von den übrigen, nicht einzeln gekühlten Baugruppen und Bauelementen erzeugte Wärmeverlustleistung über das Medium Luft abgeführt werden.

Sowohl bei Kühlvorrichtungen, die aus einem Kühlkörper und einem Lüfter bestehen, als auch bei Kühlvorrichtungen mit von einem flüssigen Wärmeträgermedium durchströmten Kühlkörper besteht das Problem, dass diese möglichst gut wärmeleitend auf dem zu kühlenden elektronischen Bauelement, meist einem Bauelement mit einem Halbleiterchip, befestigt werden müssen. Zur Gewährleistung eines guten Wärmeübergangs wird meist eine Wärmeleitpaste zwischen der thermischen Schnittstelle des Bauelements und dem Kühlkörper verwendet. Zudem ist ein ausreichender Anpressdruck erforderlich. Muss der Kühlkörper abgenommen werden, beispielsweise weil der damit integriert ausgebildete Lüfter defekt ist oder weil im engen Gehäuse der Elektronikkomponente Manipulationen an eng benachbarten Baugruppen oder Bauteilen erforderlich sind, so besteht bei jeder Demontage bzw. Montage des Kühlkörpers unmittelbar auf dem empfindlichen elektronischen Bauteil das Risiko, dieses zu beschädigen bzw. zu zerstören.

Soll eine Elektronikkomponente aus einem Rack herausgezogen und ausgetauscht werden, und wird bei dieser Elektronikkomponente eine an sich bekannte Kühlvorrichtung unter Verwendung eines flüssigen Wärmeträger- bzw. Kühlmediums verwendet, so müssen entweder die Zuführleitungen für das Kühlmedium, vorzugsweise an Kupplungen, getrennt werden, oder es muss die gesamte Kühlvorrichtung von dem zu kühlenden elektronischen Bauelement abgenommen und das Risiko in Kauf genommen werden, dieses zu beschädigen. Bei einem Trennen der Zuführleitungen besteht jedoch ebenfalls ein erhebliches Risiko, diese Elektronikkomponente oder benachbarte Elektronikkomponenten zu beschädigen, wenn auch nur eine geringe Menge des Kühlmediums austritt. Dies gilt insbesondere dann, wenn die Elektronikkomponente während des Betriebs der übrigen Elektronikkomponenten ausgetauscht werden soll (hot plugging).

Aus der WO 02/102124 A1 ist eine Kühlvorrichtung für elektronische Einrichtungen bekannt. In diesem Zusammenhang ist beschrieben, einen Kühlaufsatz direkt auf einem Mikroprozessor aufzubringen und den Aufsatz über einen Kühlkreislauf mit einem Wärmetauscher zu verbinden. Der Wärmetauscher kann eine rippenförmige Oberfläche aufweisen, wobei an dem Wärmetaucher ein zweiter Wärmetauscher angebracht ist. In dem zweiten Wärmetauscher können im Rahmen des Körpers des Wärmetauschers Kanäle vorgesehen sein.

Die US 5,982,616 offenbart ein Kühlsystem für elektronische Geräte. Auch hier sind wiederum zur vereinfachten Anbringung zwei separate Kühlkörper vorgesehen.

Aus der US 2002/021557 A1 ist eine Kühlung für ein Motherboard und andere zu kühlende Elemente bekannt. Hierzu wird über eine Verbindungsstruktur, welche über eine thermisch und mechanisch lösbare Kopplung angebracht ist, mit Hilfe von kaltem Wasser ein Wärmeabtransport realisiert.

Ausgehend von diesem Stand der Technik liegt der Erfindung die Aufgabe zugrunde, eine Kühlvorrichtung für ein elektronisches Bauelement, insbesondere für einen Mikroprozessor, zu schaffen, bei welcher der eigentliche Kühlkörper einfach, schnell und ohne das Risiko einer Beschädigung oder Zerstörung des zu kühlenden elektronischen Bauelements montierbar und demontierbar ist. Des Weiteren liegt der Erfindung die Aufgabe zugrunde, ein Rack zur Aufnahme mehrerer Elektronikkomponenten, wie Server für Datenverarbeitungsanlagen, unter Verwendung derartiger Kühlvorrichtungen zu schaffen, die von einem flüssigen Wärmeträgermedium gekühlt werden.

Die Erfindung löst diese Aufgaben mit den Merkmalen der Patentansprüche 1 bzw. 8.

Die Erfindung geht von der Erkenntnis aus, dass mittels eines Kühlkörpers, der ein erstes Kühlkörperteil umfasst, welches zur Verbindung mit dem elektronischen Bauelement ausgebildet ist, und ein zweites Kühlkörperteil, welches lösbar mit dem ersten Kühlkörperteil derart verbunden ist, dass ein geringer Wärmeübergangswiderstand gegeben ist, wobei zumindest der überwiegende Teil der Verlustwärme über das zweite Kühlkörperteil an ein Kühlmedium abgegeben wird, der Vorteil erreicht wird, dass zur erstmaligen Montage der Kühlvorrichtung lediglich das erste Kühlkörperteil einmalig mit dem zu kühlenden elektronischen Bauelement thermisch gekoppelt und fixiert werden muss. Dies kann bereits vom Hersteller der Elektronikkomponente werksseitig erfolgen. Darüber hinaus kann das erste Kühlkörperteil auch vom Hersteller des zu kühlenden elektronischen Bauelements auf diesem montiert werden. Das erste Kühlkörperteil kann auch integriert mit dem Gehäuse des elektronischen Bauelements ausgebildet sein, insbesondere unlösbar mit diesem verbunden sein.

Der zweite Kühlkörperteil kann dann ohne die Gefahr einer Beschädigung des elektronischen Bauelements mit dem ersten Kühlkörperteil gut thermisch leitend verbunden werden. Das zweite Kühlkörperteil kann dann bedarfsweise wieder problemlos vom ersten Kühlkörperteil getrennt werden.

Dieser Vorteil tritt insbesondere, jedoch nicht ausschließlich, bei der Ausbildung der Kühlvorrichtung zu Tage, bei der der zweite Kühlkörper als mit von flüssigem Kühlmedium durchströmter Kühlkörper ausgebildet ist. Hierzu weist das zweite Kühlkörperteil wenigstens einen Kanal auf, der von einem flüssigen Kühlmedium, beispielsweise Wasser, durchströmt wird. Des Weiteren sind am zweiten Kühlkörperteil ein Zulaufanschluss und ein Rücklaufanschluss vorgesehen, die mit dem wenigstens einen Kanal verbunden sind. Soll die Elektronikkomponente, welche das zu kühlende elektronische Bauelement umfasst, ausgetauscht werden, so muss nicht mehr zwingend entweder der gesamte Kühlkörper (bestehend aus dem ersten und zweiten Kühlkörperteil) demontiert oder, bei einem Belassen des Kühlkörpers auf dem elektronischen Bauelement, die Zuführleitungen für das Kühlmedium vom Kühlkörper getrennt werden. Vielmehr kann einfach und schnell lediglich das zweite Kühlkörperteil vom ersten Kühlkörperteil getrennt und beispielsweise auf ein weiteres erstes Kühlkörperteil, welches bereits auf dem betreffenden zu kühlenden elektronischen Bauelement einer Austausch-Elektronikkomponente befestigt ist, montiert werden.

Erfindungsgemäß umfasst das erste Kühlkörperteil eine Kontaktfläche zur thermischen Verbindung mit dem zweiten Kühlkörperteil, welche eine Struktur zur Vergrößerung der Kontaktfläche aufweist, wobei die Kontaktfläche des ersten Kühlkörperteils mit einer komplementär ausgebildeten Kontaktfläche des zweiten Kühlkörperteils zusammenwirkt. Dabei kann die Fläche der thermischen Schnittstelle zwischen dem ersten und zweiten Kühlkörperteil größer sein als die Fläche der thermischen Schnittstelle zwischen dem zu kühlenden elektronischen Bauelement und dem ersten Kühlkörperteil. In vorteilhafter Weise wird die Strukur zur Vergrößerung der Kontaktfläche zwischen dem ersten und zweiten Kühlkörperteil zumindest in demjenigen (horizontalen Querschnitts-) Bereich des ersten Kühlkörperteils vorgesehen, in dem das erste Kühlkörperteil mit dem zu kühlenden elektronischen Bauelement in Kontakt steht, also im Bereich des sogenannten hot Spots (in Draufsicht auf das Bauelement bzw. die Kühlvorrichtung gesehen).

Die Strukturen sind als Rippen mit schrägen, vorzugsweise ebenen Flanken ausgebildet und weisen vorzugsweise einen trapezförmigen Querschnitt auf. Eine derartige Struktur weist den Vorteil auf, dass zur Realisierung des zweiten Kühlkörpers einfach, hochgenau und kostengünstig herstellbare Strangprofile verwendet werden können. Zudem kann der Flankenwinkel so gewählt werden, dass bereits durch relativ geringe Anpresskräfte, die auf das zweite Kühlkörperteil in Richtung auf das erste Kühlkörperteil wirken, eine hohe Flächenpressung zwischen den komplementären Strukturen des ersten und zweiten Kühlkörperteils entstehen und somit ein geringer Wärmeübergangswiderstand gewährleistet wird.

Dieser Vorteil kann selbstverständlich nicht nur mit komplementären rippenförmigen Strukturen erreicht werden, sondern ganz allgemein mit Strukturen, die Teilflächen aufweisen, die unter einem geeigneten Winkel gegenüber der Richtung der Anpresskraft geneigt sind, die auf das erste Kühlkörperteil in Richtung auf das zweite Kühlkörperteil wirkt. Beispielsweise kann eine "Igelstruktur" verwendet werden, bei der eine Vielzahl von zackenartigen Fortsätzen an der Unterseite des zweiten Kühlkörperteils mit einer entsprechenden komplementären Struktur auf der Oberfläche des ersten Kühlkörperteils zusammenwirkt. Die zackenartigen Fortsätze weisen dabei entsprechend geneigte Außenflächen auf.

Erfindungsgemäß sind zumindest in Rippen der Kontaktfläche des zweiten Kühlkörperteils Kanäle für das Kühlmedium vorgesehen. Hierdurch ergibt sich der Vorteil, dass der oder die Ströme des Kühlmediums nahe an der Oberfläche des zu kühlenden Bauelements liegen.

Die Kanäle können so in den jeweiligen Rippen angeordnet sein, dass zumindest in wesentlichen Bereichen dieser Rippen, die in Kontakt mit entsprechenden komplexentären Rippen des ersten Kühlkörperteils stehen, durch das Vorsehen der Kanäle relativ dünne Wandungen entstehen. Diese Wandungen können hinsichtlich ihrer Dicke, abhängig vom Material und den Anpresskräften so dimensioniert sein, dass sie bei Einwirken der Anpresskräfte leichte Deformationen zulassen, um so ein möglichst flächiges Anliegen der Außenseiten dieser Wandungen an die komplementären Rippen des ersten Kühlkörperteils und damit einen guten Wärmeübergang zu gewährleisten.

Nach einer bevorzugten Ausführungsform kann das zweite Kühlkörperteil im Bereich des Zulaufanschlusses und/oder des Rücklaufanschlusses eine Sammelkammer aufweisen, von der aus sich mehrere Kanäle für das Kühlmedium verzweigen oder in diese münden. Hierdurch wird ein guter Wärmeübergang auf das flüssige Kühlmedium erreicht, da eine größere Oberfläche erreichbar ist, als bei einem einzigen, ggf. im Querschnitt größeren Kanal. Zudem kann der mittlere Bereich des zweiten Kühlkörpers mit einem Strangprofil realisiert werden, welches an gegenüberliegenden Seiten jeweils mit einem die Sammelkammer bildenden und den betreffenden Zulauf- bzw. Rücklaufanschluss aufweisenden Teil verbunden wird.

Das zweite Kühlkörperteil kann in zumindest einer Richtung, bezogen auf die Kontaktfläche, mit dem ersten Kühlkörperteil größere Abmessungen als das erste Kühlkörperteil aufweisen. Hierdurch ergibt sich der Vorteil, dass die Position des ersten Kühlkörperteils gegenüber dem zweiten Kühlkörperteil bei der Montage des zweiten Kühlkörperteils auf dem ersten Kühlkörperteil unkritisch ist. Beispielsweise kann bei einer Ausbildung der die Kontaktfläche erhöhenden Struktur in Form von Rippen das zweite Kühlköperteil gegenüber dem ersten. Kühlkörperteil ohne Weiteres geringfügig verschoben werden.

Des Weiteren kann das zweite Kühlkörperteil so ausgebildet werden, dass mittels des Kühlmitteldurchflusses durch den wenigstens einen Kanal in der Kontaktfläche mit dem ersten Kühlkörperteil eine bezogen auf die Kontaktfläche im Wesentlichen gleichmäßige Wärmeableitung möglich ist. Insbesondere bei Ausbildung mehrerer Kanäle in einem mittleren Bereich des zweiten Kühlkörpers können diese über die gesamte tatsächliche Kontaktfläche mit dem ersten Kühlkörperteil ausgebildet sein. Ggf. vorhandene Sammelkammern an einem oder beiden Enden dieses mittleren Bereichs können dann, bezogen auf die tatsächliche Kontaktfläche, außerhalb dieser liegen.

Es können auch lediglich ein oder mehrere Kühlrippen mit jeweils wenigstens einem Kanal ausgebildet sein, welche sich im Bereich des sogenannten "hot spots" des zu kühlenden elektronischen Bauelements befinden. Durch die eine oder mehreren Rippen und das Vorsehen des oder der Kanäle derart, dass sie im vorderen Bereich der Rippe(n) liegen, kann die Verlustwärme unmittelbar in der Umgebung, in der sie erzeugt wird, auf das Kühlmedium übertragen werden.

In einer Ausgestaltung der Erfindung kann das erste Kühlkörperteil als Heatpipe ausgebildet sein. Eine Heatpipe transportiert mittels eines evakuierten Gefäßes, z.B. einem Metallrohr, gerichtet Wärme von einem Punkt zum anderen. Im Metallrohr selbst befindet sich ein relativ geringes Volumen einer Flüssigkeit, die zum überwiegenden Teil aus destilliertem Wasser bestehen kann (der restliche Anteil besteht dann aus speziellen Zutaten, die den Wärmetransport optimieren sollen). Die Flüssigkeit steht unter einem niedrigen Druck, so dass eine Verdampfungstemperatur von zirka 30 Grad Celsius auftritt. Erst wenn der Heatpipe an einem Ende Wärme zugeführt wird, verdampft das Wasser und transportiert die Wärmeenergie sehr verlustarm zum kalten Ende. Dort erfolgt eine Kondensation des Dampfes und entsprechend eine Abgabe der Wärme. Die kondensierte Flüssigkeit läuft wieder in den unteren Bereich des Gefäßes zurück, wodurch der Kreislauf geschlossen ist.

Durch die Ausbildung des ersten Kühlkörperteils als Heatpipe kann die abzuführende Wärme extrem verlustarm an eine Stelle transportiert werden, an der diese mittels des zweiten Kühlkörperteils an das Kühlmedium übergehen und endgültig abgeführt werden kann. Beispielsweise kann so die Schnittstelle zum zweiten Kühlkörperteil bis an eine Stelle außerhalb eines Gehäuses verlagert werden, wobei das betreffende Ende der Heatpipe durch eine Öffnung im Gehäuse ragen kann. Bei einem Austausch der gesamten Komponente muss dann nicht einmal das Gehäuse geöffnet werden. Es ist lediglich erforderlich, das zweite Kühlkörperteil vom ersten Kühlkörperteil zu lösen.

Ein erfindungsgemäßes Rack zur Aufnahme mehrerer Elektronikkomponenten, wie Server für Datenverarbeitungsanlagen, ist zur Kühlung von elektronischen Bauelementen in den einzelnen Elektronikkomponenten ausgebildet, wobei mehrere Kühlvorrichtungen nach der Erfindung mit einem von einem flüssigen Kühlmedium durchströmten zweiten Kühlkörperteil vorgesehen sind. Die zweiten Kühlkörperteile der Kühlvorrich-tungen können mit ihren Zulauf- und Rücklaufanschlüssen mit einem oder mehreren zentralen Kühlmittelreservoires oder einem oder mehreren zentralen Wärmetauschern verbunden sein, über welche dem Kühlmedium Wärme entzogen wird.

Nach einer Ausführungsform können das eine oder die mehreren zentralen Kühlmittelreservoires oder der eine oder die mehreren zentralen Wärmetauscher im oder am Rack angeordnet sein.

Im Rack kann jedoch auch lediglich ein Leitungssystem vorgesehen sein, welches die Zulaufanschlüsse der Kühlvorrichtungen mit einem oder mehreren zentralen Zulaufanschlüssen des Racks und die Rücklaufanschlüsse der Kühlvorrichtungen mit einem oder mehreren zentralen Rücklaufanschlüssen des Racks verbindet.

Nach einer Ausführungsform ist im Rack wenigstens eine fest im Rack angeordnete, vorzugsweise starre Zulauf-Steigleitung vorgesehen, welche mehrere Anschlüsse für vorzugsweise flexible Verbindungsleitungen von jeweils einem Anschluss zu einem Zulaufanschluss eines zweiten Kühlkörperteils einer Kühlvorrichtung aufweist. In gleicher Weise ist im Rack wenigstens eine fest im Rack angeordnete, vorzugsweise starre Rücklauf-Steigleitung vorgesehen, welche mehrere Anschlüsse für vorzugsweise flexible Verbindungsleitungen von jeweils einem Anschluss zu einem Rücklaufanschluss eines zweiten Kühlkörperteils einer Kühlvorrichtung aufweist.

Weitere Ausführungsformen der Erfindung ergeben sich aus den Unteransprüchen.

Die Erfindung wird nachfolgend anhand einer in der Zeichnung dargestellten Ausführungsform näher erläutert. In der Zeichnung zeigen:
- Fig. 1: eine perspektivische Darstellung einer Ausführungsform einer Kühlvorrichtung nach der Erfindung unter Verwendung eines flüssigen Kühlmediums;
- Fig. 2: eine perspektivische Schnittdarstellung der Ausführungsform in Fig. 1 und
- Fig. 3: eine schematische Seitenansicht einer Ausführungsform eines Racks nach der Erfindung für mehrere Elektronikkomponenten mit einem Leitungssystem für das Kühlmedium, welches jeweils einen zentralen Zulauf- und Rücklaufan- schluss aufweist;
- Fig. 4: eine schematische Darstellung einer weiteren Ausführungsform einer Kühlvor- richtung nach der Erfindung in einer (teilweisen) Schnittdarstellung und
- Fig. 5: eine schematische, perspektivische Explosionsdarstellung einer weiteren Aus- führungsform einer Kühlvorrichtung nach der Erfindung mit einer vorteilhaften Montageeinrichtung.

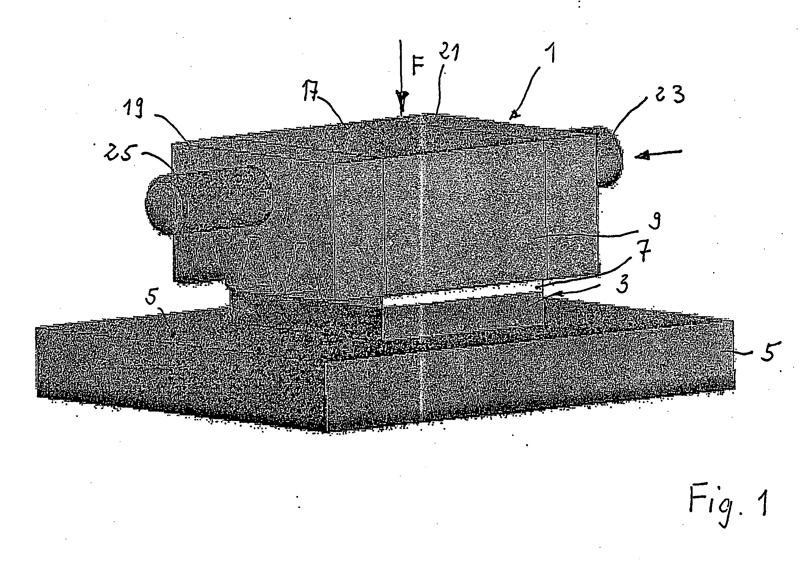

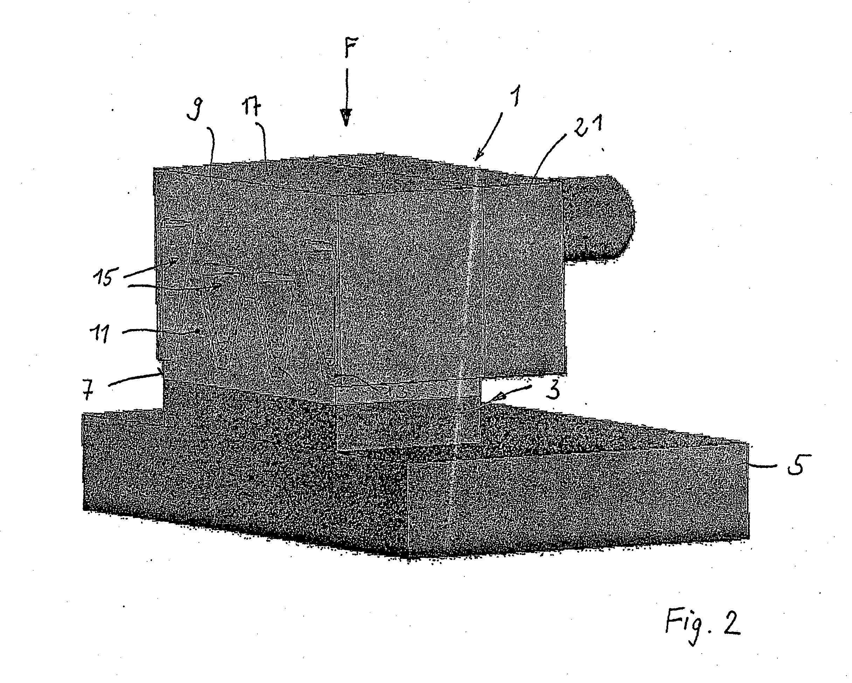

Fig. 1 zeigt in perspektivischer Ansicht schematisch eine Kühlvorrichtung 1, die auf einem elektronischen Bauelement 3, beispielsweise einem Mikroprozessor, montiert ist. Der Mikroprozessor 3 ist seinerseits auf einer nur angedeuteten Platine 5 angeordnet, auf der selbstverständlich weitere Bauelemente oder Baugruppen vorgesehen sein können. Bei der Platine 5 kann es sich beispielsweise um ein Mainboard eines Servers handeln. Die Kühlvorrichtung 1 umfasst ein erstes Kühlkörperteil 7 aus einem gut wärmeleitenden Material, beispielsweise Aluminium oder Kupfer, welches unmittelbar mit dem Gehäuse bzw. einer thermischen Schnittstelle des zu kühlenden elektronischen Bauelements thermisch leitend verbunden ist. Dabei kann es sich beispielsweise um eine Wärmeableitplatte (heat spreader) eines Mikroprozessors bzw. des elektronischen Bauelements 3 handeln. Das erste Kühlkörperteil 7 weist an seiner dem Bauelement 3 abgewandten Seite eine Struktur in Form von Rippen 11 auf, die, wie in Fig. 2 dargestellt, einen trapezförmigen Querschnitt aufweisen können.

Auf dem ersten Kühlkörperteil 7 ist ein zweites Kühlkörperteil 9 aus einem gut wärmeleitenden Material, beispielsweise Aluminium oder Kupfer, angeordnet und thermisch gut leitend mit diesem verbunden. Hierzu ist das zweite Kühlkörperteil 9 an seiner Unterseite mit einer komplementär ausgebildeten Struktur in Form von Rippen 13 versehen. In den Rippen 13 verlaufen Kanäle 15 für ein flüssiges, die Kanäle 15 durchströmendes Kühlmedium (nicht dargestellt), welches die vom elektronischen Bauelement 3 in Form von Wärme erzeugte Verlustleistung abtransportiert. Die Anordnung der Kanäle 15 in den Rippen bietet den Vorteil, dass bei entsprechend dünnen Wandungen der Rippen 15 das Kühlmedium nahe der Oberfläche des Bauelements 3 geführt werden kann, insbesondere auch zwischen den Rippen 11 des ersten Kühlkörperteils 7.

Die trapezförmige Ausbildung der Rippen 11 und 13 bieten zudem den Vorteil, dass mit einer geringen Anpresskraft F, die auf das zweite Kühlkörperteil 9 in Richtung auf das erste Kühlkörperteil 7 wirkt, ein hoher Anpressdruck der Seitenflächen der trapezförmigen Rippen 11 und 13 erzeugt und demzufolge eine gute thermische Kopplung gewährleistet werden kann.

Der die Rippen 13 aufweisende mittlere Bereich 17 des zweiten Kühlkörperteils 9 ist in seiner Ausdehnung (parallel zur Oberfläche des Bauelements 3) wenigstens so groß wie die Ausdehnung der die Rippen 11 aufweisenden Oberfläche des ersten Kühlkörperteils 7. Auf diese Weise kann bei einer entsprechenden Anordnung und Ausbildung der Kanäle 15 ein im Wesentlichen konstanter Wärmeübergangswiderstand in der Kontaktfläche der beiden Kühlkörperteile 7 und 9 - zumindest entlang von Linien parallel zur Längsrichtung der Rippen - erreicht werden. Ein derart ausgebildeter mittlerer Bereich 17 hat zudem den Vorteil, dass er aus einem hochgenau und kostengünstigen Strangprofil hergestellt werden kann. Dies gilt auch für das erste Kühlkörperteil 7.

Der in den Fig. 1 bzw. 2 erkennbare, sich an den beiden Enden des mittleren Bereichs des zweiten Kühlkörperteils 9 jeweils anschließende Endbereich 19 bzw. 21, kann hinsichtlich der Außenkontur identisch wie der mittlere Bereich 17 ausgebildet sein. Im Inneren der Endbereiche 19, 21 ist jedoch jeweils eine Sammelkammer (nicht dargestellt) vorgesehen, welche jeweils mit den Kanälen 15 verbunden ist. Die Bereiche 17, 19, 21 können selbstverständlich einstückig ausgebildet sein. Beispielsweise kann ein Endbereich 19, 21 dadurch hergestellt werden, dass in den Endbereichen eines entsprechenden Strangprofils von beiden Seiten jeweils die inneren Wandungen zwischen den Kanälen 15 teilweise oder ganz entfernt, beispielsweise ausgefräst werden. Die beiderseitigen Öffnungen des Strangprofils können dann mit entsprechenden Deckeln verschlossen werden, beispielsweise durch Verlöten oder dergleichen.

An den Stirnseiten der Endbereiche 19, 21 sind ein Zulaufanschluss 23 für eine Zulaufleitung und ein Rücklaufanschluss 25 für eine Rücklaufleitung vorgesehen. Das Kühlmedium wird bei der gegebenen (ausreichend niedrigen) Temperatur mit einem für die Kühlung ausreichenden Massenstrom über die Zulaufleitung der Kühlvorrichtung 1 zugeführt und über die Rücklaufleitung abgeführt.

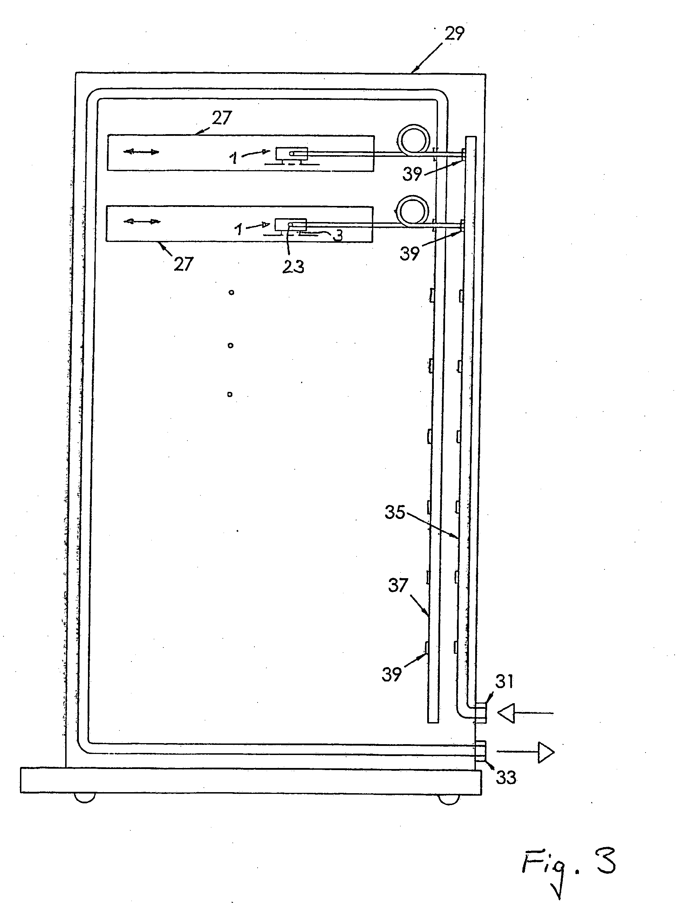

Die Montage des ersten Kühlkörperteils 7 auf dem elektronischen Bauelement 3 kann in üblicher Weise mittels einer geeigneten Verschraubung oder mittels Klammern oder anderen geeigneten Verbindungsmitteln erfolgen. Selbstverständlich kann das erste Kühlkörperteil hierzu beispielsweise seitlich angeordnete Befestigungsmittel aufweisen, die auch seitlich über die Oberfläche des Bauelements 3 hinausragen können. Das Fixieren des ersten Kühlkörperteils 7 auf dem Bauelement 3 kann gegenüber der Platine 5 oder einem nicht dargestellten Gehäuse einer Elektronikkomponente 27 (Fig. 3) erfolgen, in welcher die Platine 3 angeordnet ist. Das erste Kühlkörperteil 7 kann jedoch auch unlösbar mit dem Bauelement 3 verbunden sein, beispielsweise durch Verkleben mit einem wärmeleitenden Klebstoff, oder sogar einstückig mit dem Gehäuse des Bauelements 7 ausgebildet sein.

Auch die Verbindung des zweiten Kühlkörperteils 9 mit dem ersten Kühlkörperteil 7 kann mittels geeigneter, jedoch in jedem Fall lösbarer Verbindungsmittel erfolgen, beispielsweise durch Verschrauben, mittels Fixierklammern oder dergleichen. Das Anpressen des Kühlkörperteils 9 auf das Kühlkörperteil 7 mit ausreichendem Druck kann auch durch das Aufsetzen und Anpressen eines Gehäuseteils eines Gehäuses einer Elektronikkomponente 27 erfolgen, in welchem die Platine 5 mit dem zu kühlenden Bauelement 3 und der darauf angeordneten Kühlvorrichtung 1 enthalten ist.

Durch diese spezielle Ausbildung der Kühlvorrichtung ergibt sich der Vorteil, dass das als eigentlicher Kühlköper wirkende zweite Kühlkörperteil 9 vom ersten Kühlkörperteil 7 gelöst werden kann, ohne dass die mechanisch empfindliche thermische Schnittstelle zwischen dem zu kühlenden Bauelement 3 und dem ersten Kühlkörperteil gelöst werden muss.

Fig. 3 zeigt schematisch ein Rack 29 in Seitenansicht, in dem eine Mehrzahl von Elektronikkomponenten 27, beispielsweise Server für eine größere EDV-Anlage, aufgenommen werden können. Aus Gründen der Einfachheit wurden in Fig. 3 lediglich zwei Elektronikkomponenten 27 eingezeichnet.

Jede der Elektronikkomponenten kann ein oder mehrere zu kühlende Bauelemente 3 aufweisen, die mit einer Kühlvorrichtung 1 nach der Erfindung gekühlt werden. Selbstverständlich kann die übrige von einer Elektronikkomponente 27 erzeugte Verlustwärme in herkömmlicher Weise mittels Lüftern in das Innere des Racks 29 und von da an die Umgebung abgegeben werden.

Zur Versorgung der Kühlvorrichtungen 1 mit einem Kühlmedium kann; wie in Fig. 3 dargestellt, im Rack ein Leitungssystem angeordnet sein, welches das Kühlmedium von einem zentralen Zulaufanschluss 31 des Racks 29 den Zulaufanschlüssen 23 der einzelnen Kühlvorrichtungen 1 zuführt und von den Rücklaufanschlüssen 25 der einzelnen Kühlvorrichtungen 1 einem zentralen Rücklaufanschluss 33 des Racks 29 zuführt. Das Kühlmedium kann dem zentralen Zulaufanschluss 31 des Racks 29 von einer zentralen Kühleinrichtung (nicht dargestellt) zugeführt und vom zentralen Rücklaufanschluss 33 des Racks 29 wieder an diese zurückgeführt werden.

Selbstverständlich ist es nicht zwingend notwendig, alle Kühlvorrichtungen 1 einzeln parallel zwischen den zentralen Zulauf und den zentralen Rücklauf des Racks 29 zu schalten. Vielmehr können auch mehrere oder alle Kühlvorrichtungen 1 in Reihe geschaltet werden, wenn die Temperatur des Kühlmediums nach dem Verlassen der jeweils vorgeschalteten Kühlvorrichtung 1 und der jeweilige Massenstrom des Kühlmediums dies zulassen. Insbesondere können für den Fall, dass in einer Elektronikkomponente mehrere Kühlvorrichtungen 1 vorgesehen sind, diese Kühlvorrichtungen in Reihe geschaltet werden.

Wie in Fig. 3 dargestellt, kann das im Rack angeordnete Leitungssystem eine Zulaufsteigleitung 35 umfassen, welche das Kühlmedium vom zentralen Zulaufanschluss 31 des Racks 29 zu einzelnen Anschlüssen 39 führt, welche jeweils mit einem Zulaufanschluss 23 einer Kühlvorrichtung 1 verbunden bzw. verbindbar sind. Die Zulaufsteigleitung kann aus einer starren, fest mit dem Rack verbundenen Leitung bestehen. Die Leitungen zwischen den Anschlüssen 39 und dem jeweiligen Zulaufanschluss 23 der betreffenden Kühlvorrichtung 1 können flexibel ausgebildet sein und erforderlichenfalls eine ausreichende Überlänge aufweisen. Dies ermöglicht das Herausziehen der betreffenden Elektronikkomponente 27 aus dem Rack, beispielsweise um dessen Gehäuse zu öffnen und Reparaturen vorzunehmen oder Komponenten auszutauschen, ohne dass die Kühlvorrichtung(en) 1 der Elektronikkomponente vom übrigen Leitungssystem getrennt werden müssen.

In gleicher Weise kann eine analog ausgebildete Rücklaufsteigleitung 37 vorgesehen sein, die ebenfalls Anschlüsse 39 für Verbindungsleitungen (nicht dargestellt) zwischen den Rücklaufanschlüssen 25 jeweils einer Kühlvorrichtung 1 und der Rücklaufsteigleitung 37 besitzt. Auch diese Verbindungsleitungen können flexibel sein und eine ausreichende Überlänge aufweisen.

Wie in Fig. 3 dargestellt, sind die Steigleitungen 35 und 37 so ausgebildet und so angeschlossen, dass sich für jede Elektronikkomponente 27 bzw. die darin angeordneten Kühlvorrichtungen 1 (genauer: für den Teilstrom des Kühlmittels durch dies betreffenden Kühlvorrichtungen) zwischen dem Zulaufanschluss 31 und dem Rücklaufanschluss 33 die selbe Leitungslänge ergibt. Dies wird bei der in Fig. 3 dargestellten Ausführungsform dadurch erreicht, dass die eigentlichen Steigleitungsbereiche der Steigleitungen 35, 37 vorzugsweise im Wesentlichen parallel verlaufen und in jedem Fall die Anschlüsse 39 der Zulauf Steilgleitung 35 und der Rücklauf-Steigleitung 37 so angeordnet sind, dass die Summe der Leitungslänge zwischen dem Zulaufanschluss 31 und dem betreffenden Anschluss 39 der Zulauf Steigleitung 35 und der Leitungslänge zwischen dem betreffenden Anschluss 39 der Rücklauf-Steigleitung 37 und dem Rücklaufanschluss 33 für alle Elektronikkomponenten bzw. alle Paare von "zusammengehörigen" Anschlüssen 39 der Zulauf-Steigleitung 35 und der Rücklauf-Steigleitung 37 jeweils im Wesentlichen konstant ist. Sind die eigentlichen, in Fig. 3 vertikal verlaufenden Steigleitungsbereiche der Zulauf- und Rücklauf-Steigleitungen 35, 37 parallel geführt, so können hierzu die "zusammengehörigen" Anschlüsse 39 im Wesentlichen auf der selben Höhe vorgesehen sein, vorzugsweise in jeweils der Höhe, in der auch die anzuschließende Elektronikkomponente 27 im Rack 29 gehalten wird.

In einer anderen, nicht dargestellten Ausführungsform kann auch im Rack selbst ein zentraler Wärmetauscher bzw. eine Einrichtung zur Abfuhr der vom Kühlmedium aufgenommenen Wärmeenergie an die Umgebungsluft vorgesehen sein.

Auch diese Ausführungsform kann zentrale Steigleitungen für den Zulauf und den Rücklauf entsprechend Fig. 3 aufweisen. Die Anschlüsse für den zentralen Zulauf und den zentralen Rücklauf müssen dann jedoch nicht nach außen geführt sein, sondern können mit dem zentralen Wärmetauscher bzw. der Einrichtung zur Abfuhr der vom Kühlmedium aufgenommenen Wärmeenergie verbunden sein.

Ein derart ausgebildetes Rack bietet den Vorteil, dass ein Austausch einer gesamten Elektronikkomponente möglich ist, ohne dass die Kühlvorrichtung vom Kühlkreislauf getrennt werden müsste. Es muss lediglich das bzw. jedes zweite Kühlkörperteil 9 vom betreffenden ersten Kühlkörperteil 7 gelöst werden. Die Austauschkomponente, die bereits das bzw. die vormontierten ersten Kühlkörperteile 7 aufweist, kann dann einfach in das Rack eingeschoben werden. Es müssen lediglich die zweiten Kühlkörperteile 9 wieder mit den betreffenden ersten Kühlkörperteilen 7 verbunden werden. Es besteht keine Gefahr, dass durch ein Auftrennen einer Leitung für das Kühlmedium an der Koppelstelle Kühlmedium austritt und hierdurch eine oder mehrere Elektronikkomponenten beschädigt werden. Hierdurch kann insbesondere ein sehr sicheres hot plugging von Elektronikkomponenten gewährleistet werden.

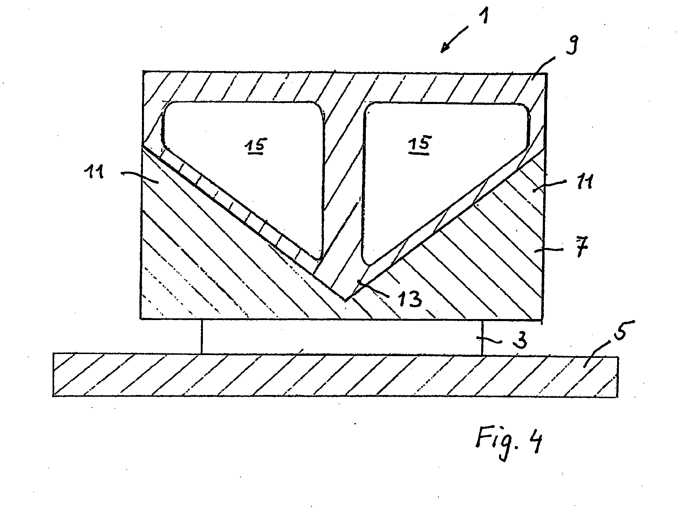

Fig. 4 zeigt eine weitere Ausführungsform zur Realisierung einer ein erstes Kühlkörperteil 7 und ein zweites Kühlkörperteil 9 umfassenden Kühlvorrichtung 1. Anders als die in den Fig. 1 und 2 dargestellte Ausführungsform, bei der das zweite Kühlkörperteil 9 vier sich nach unter erstreckende Rippen aufweist, besitzt das zweite Kühlkörperteil 9 der in Fig. 4 dargestellten Ausführungsform lediglich eine einzige, sich nach unten erstreckende Rippe 13. Diese Rippe 13 greift in eine zwischen zwei sich nach oben erstreckende Rippen 11 des ersten Kühlkörperteils 7 ausgebildete Vertiefung ein und ist zu dieser im Wesentlichen komplementär ausgebildet. Hierdurch ergibt sich zwar im Vergleich zur Ausführungsform nach den Fig. 1 und 2 eine reduzierte Wärmeübergangsfläche zwischen den Kühlkörperteilen 7 und 9, jedoch sind die einzige V-förmige Rippe 13 des zweiten Kühlkörperteils 9 und die V-förmige Vertiefung zwischen den beiden Rippen 11 des ersten Kühlkörperteils bedeutend einfacher zu fertigen. Die Toleranzen, die einzuhalten sind, um einen flächigen Wärmekontakt zwischen den Kühlkörperteilen 7, 9 zu erzielen, sind weit weniger kritisch als bei der Ausführungsform nach den Fig. 1 und 2. An dieser Stelle sei bemerkt, dass es aus diesem Grund fertigungstechnisch vorteilhafter ist, einige wenige Rippen 13 bzw. 11 am zweiten bzw. am ersten Kühlkörperteil vorzusehen, z.B. maximal vier bis sechs Rippen 13 am zweiten Kühlkörperteil und drei bis fünf Rippen 11 am ersten Kühlkörperteil, die sich dafür jeweils über eine größere Höhe in Richtung in das jeweils andere Kühlkörperteil hinein erstrecken, als eine Vielzahl von Rippen mit kleinerer Höhe.

Das zweite Kühlkörperteil 9 der Ausführungsform einer Kühlvorrichtung nach Fig. 4 umfasst zwei Kanäle 15 zur Leitung des Kühlmediums in der Rippe 13 des zweiten Kühlkörperteils 9. Statt dessen können jedoch auch lediglich ein einziger, vorzugsweise zentral verlaufender Kanal oder mehrere Kanäle vorgesehen sein.

Des Weiteren kann der Querschnitt des ersten Kühlkörperteils 7 auch mit dem Querschnitt des zweiten Kühlkörperteils 9, bis auf die Kanäle 15, vertauscht sein (nicht dargestellte Ausführungsform). D.h., das erste Kühlkörperteil 7 kann einen einzigen, sich nach oben erstreckenden Vorsprung 11 aufweisen, der in eine zwischen zwei sich nach unten erstreckende Vorsprünge 13 ausgebildete Vertiefung eingreift. Dabei können in jedem der Vorsprünge 13 des zweiten Kühlkörperteils ein oder mehrere Kanäle 15 ausgebildet sein.

Generell ist es vorteilhaft, die Abmessungen des ersten und zweiten Kühlkörperteils 7, 9 in der Draufsicht größer zu wählen als die zu kühlende Oberfläche des zu kühlenden elektronischen Bauelements 3, um eine größere Fläche für den Wärmeübergang vom ersten Kühlkörperteil 7 auf das zweite Kühlkörperteil 9 zu schaffen und vom zweiten Kühlkörperteil auf das darin geführte Kühlmedium.

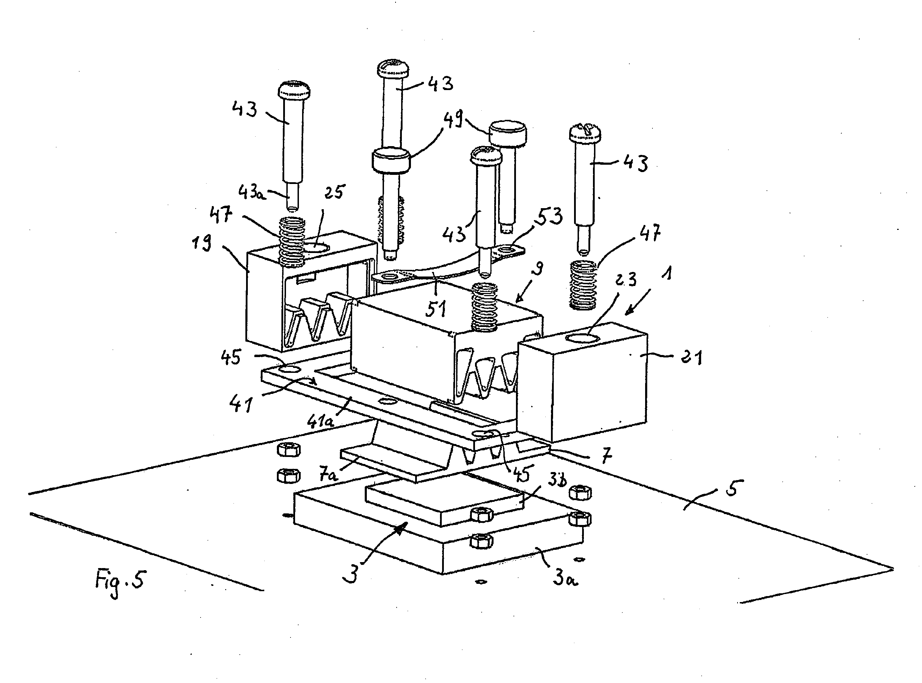

Fig. 5 zeigt eine weitere Ausführungsform einer Kühlvorrichtung 1 in einer perspektivischen Explosionsansicht, welche der Ausführungsform nach den Fig. 1 und 2 ähnelt. Gegenüber der Ausführungsform nach den Fig. 1 und 2 sind jedoch die Zu- und Rücklaufanschlüsse 23, 25 an den Endbereichen 23, 21 nach oben herausgeführt.

Des Weiteren zeigt Fig. 5 eine vorteilhafte Möglichkeit zur Montage des ersten Kühlkörperteils 7 in wärmeleitendem Kontakt auf dem zu kühlenden, elektronischen Bauelement 3. Dieses Bauelement kann ein Gehäuse 3a umfassen, an dessen Oberseite der eigentlich zu kühlende Bereich 3b des Halbleiterchips vorgesehen ist.

Wie in Fig. 5 dargestellt, kann das erste Kühlkörperteil 7 mittels eines Rahmens 41, dessen parallele Längsseiten 41a mit ihren Unterseiten Bereiche 7a des ersten Kühlkörperteils 7 beaufschlagen, die sich in der Richtung quer zum Verlauf der Rippen 11 nach außen erstrecken. In den Eckbereichen des Rahmens 41 ist jeweils eine Bohrung 45 für eine Befestigungsschraube 43 vorgesehen. Die Befestigungsschrauben 43 durchgreifen mit ihrem Gewindebereich 43a die Bohrungen 45 und nehmen in ihrem Schaftbereich zwischen der Oberseite des Rahmens 41 und der Unterseite des jeweiligen Schraubenkopfes jeweils eine Schraubenfeder 47 auf. Die Länge des Schaftbereichs der Befestigungsschrauben 43 und die Länge und die Federkonstante der Schraubenfedern 47 sind so aufeinander abgestimmt, dass bei der Montage des Rahmens 41 zur Befestigung des Rahmens 41 auf dem ersten Kühlkörperteil 7 der Rahmen 41 durch eine Vorspannung der Schraubenfedern 47 mit einer definierten Federkraft auf das zu kühlende elektronische Bauelement 3 gepresst wird. Dabei kann in üblicher Weise zwischen der Oberseite des Bauelements 3 und der Unterseite des ersten Kühlkörperteils 7 eine Wärmeleitpaste oder ein wärmeleitender Kleber eingebracht sein.

Auf den so montierten Rahmen 41 und das damit gehaltene erste Kühlkörperteil 7 kann dann das zweite Kühlkörperteil 9 mittels zweier weiterer Befestigungschrauben 49 und einer federnden Halteklammer 51 montiert werden. Die Befestigungschrauben 49 durchgreifen hierzu die Halteklammer, die sich vorzugsweise quer zum Verlauf der Rippen 11 bzw. 13 der ersten bzw. zweiten Kühlkörperteils 7 bzw. 9 erstreckt, in Bohrungen 53, die in den Endbereichen der Halteklammer 51 vorgesehen sind, und greifen in Gewindebohrungen in den Längsseiten 41a des Rahmens 41 ein. Die Halteklammer ist dabei vorzugsweise mittig bezogen auf die Länge des zweiten Kühlkörperteils und des Rahmens 41 angeordnet.

Die Länge der Befestigungsschrauben 49 und die federnden Endbereiche der Halteklammer 51 sind so aufeinander abgestimmt, dass die Halteklammer 51 nach dem Einschrauben der Befestigungsschrauben 49 in den Rahmen 41 das zweite Kühlkörperteil 9 an deiner Oberseite mit einer definierten Kraft beaufschlagt, die ausreicht, um das zweite Kühlkörperteil 9 im Sinne einer ausreichend stabilen Befestigung und eines ausreichend guten Wärmeübergangs auf dem ersten Kühkörperteil zu fixieren.

Selbstverständlich kann diese Montageeinrichtung auch mit jeder der zuvor beschriebenen Ausführungsformen einer Kühlvorrichtung eingesetzt werden.

Hierdurch ist ein wesentliches Ziel und ein wesentlicher Vorteil der vorliegenden Erfindung auf einfache Weise realisiert, nämlich eine Kühlvorrichtung - einschließlich einer geeigneten Montageeinrichtung - zu schaffen, bei der die Kühlvorrichtung 1 bzw. das zweite Kühlkörperteil auf einfache Weise vom ersten Kühlkörperteil getrennt werden kann, ohne dass unmittelbar an der kritischen, weil empfindlichen Schnittstelle zwischen dem elektronischen Bauelement 3 und der Kühlvorrichtung 1 manipuliert werden muss. Auf diese Weise kann insbesondere bei Kühlvorrichtungen mit einem flüssigen Kühlmedium der Vorteil erreicht werden, dass beispielsweise zu Wartungsarbeiten oder Reparaturarbeiten an der Platine, zu denen die Platine aus dem Gerät herausgenommen werden muss, keine Auftrennung des Kühlmittelkreislaufs erfolgen muss und auch nicht die Schnittstelle zwischen dem Bauelement 3 und der Kühlvorrichtung berührt oder aufgetrennt werden muss.

## Patentansprüche

1. Kühlvorrichtung für ein elektronisches Bauelement, insbesondere für einen Mikroprozessor,
a) mit einem von einem Kühlmedium durchströmbaren Kühlkörper (7, 9), welcher derart mit dem zu kühlenden elektronischen Bauelement (3) verbindbar ist, dass die von dem elektronischen Bauelement (3) erzeugte Verlustwärme über eine thermische Schnittstelle des elektronischen Bauelements auf den Kühlkörper (7, 9) übergeht und abtransportiert wird,
b) wobei der Kühlkörper (7, 9) ein erstes Kühlkörperteil (7) umfasst, welches zur Verbindung mit dem elektronischen Bauelement (3) ausgebildet oder mit diesem verbunden ist,
c) wobei der Kühlkörper (7, 9) ein zweites Kühlkörperteil (9) umfasst, welches wenigstens einen, von dem flüssigen Kühlmittel durchströmbaren Kanal (15) aufweist,
d) wobei am zweiten Kühlkörperteil (9) ein Zulaufanschluss (23), mund ein Rücklaufanschluss (25) vorgesehen sind, die mit dem wenigstens einen Kanal (15) verbunden sind,
e) wobei das zweite Kühlkörperteil (9) lösbar mit dem ersten Kühlkörperteil (7) derart verbunden ist, dass ein geringer Wärmeübergangswiderstand gegeben ist, wobei zumindest der überwiegende Teil der Verlustwärme über das zweite Kühlkörperteil (9) an das Kühlmedium abgegeben wird, und
f) wobei das zweite Kühlkörperteil (9) vom ersten Kühlkörperteil (7) lösbar ist, ohne dass die Verbindung des ersten Kühlkörperteils (7) mit dem elektronischen Bauelement (3) gelöst werden muss,
g) wobei das erste Kühlkörperteil (7) eine Kontaktfläche zur thermischen Verbindung mit dem zweiten Kühlkörperteil (9) umfasst, welche eine Struktur (11) zur Vergrößerung der Kontaktfläche aufweist, wobei die Kontaktfläche des ersten Kühlkörperteils (7) mit einer komplementär ausgebildeten Kontaktfläche des zweiten Kühlkörperteils (9) zusammenwirkt, und
h) wobei die Strukturen als Rippen (11, 13) mit schrägen Flanken ausgebildet sind,
**dadurch gekennzeichnet,**
i) **dass** zumindest in den Rippen (13) des zweiten Kühlkörperteils (9) der wenigstens eine Kanal (15) für das Kühlmedium vorgesehen ist.

2. Kühlvorrichtung nach Anspruch 1, **dadurch gekennzeichnet, dass** die Flanken eben und vorzugsweise mit einem trapezförmigen Querschnitt ausgebildet sind.

3. Kühlvorrichtung nach einem der vorhergehenden Ansprüche, **dadurch gekennzeichnet, dass** das zweite Kühlkörperteil (9) im Bereich des Zulaufanschlusses (23) und/oder des Rücklaufanschlusses (25) eine Sammelkammer aufweist, von der aus sich mehrere Kanäle (15) für das Kühlmedium verzweigen oder in diese münden.

4. Kühlvorrichtung nach einem der vorhergehenden Ansprüche, **dadurch gekennzeichnet, dass** das zweite Kühlkörperteil (9) in zumindest einer Richtung bezogen auf die Kontaktfläche mit dem ersten Kühlkörperteil (7) größere Abmessungen als das erste Kühlkörperteil (7) aufweist und dass das zweite Kühlkörperteil (9) so ausgebildet ist, dass mittels des Kühlmitteldurchflusses durch den wenigstens einen Kanal (15) in der Kontaktfläche mit dem ersten Kühlkörperteil eine bezogen auf die Kontaktfläche im Wesentlichen gleichmäßige Wärmeableitung möglich ist.

5. Kühlvorrichtung nach einem der vorhergehenden Ansprüche, **dadurch gekennzeichnet, dass** das erste Kühlkörperteil (7) als Heatpipe ausgebildet ist.

6. Kühlvorrichtung nach einem der vorhergehenden Ansprüche, **dadurch gekennzeichnet, dass** eine Befestigungseinrichtung vorgesehen ist, welche Mittel zum vorzugsweise lösbaren Verbinden des ersten Kühlkörperteils (7) mit dem zu kühlenden elektronischen Bauelement (3) umfasst.

7. Kühlvorrichtung nach Anspruch 6, **dadurch gekennzeichnet, dass** die Befestigungseinrichtung weitere Mittel zum lösbaren Verbinden des zweiten Kühlkörperteils (9) mit dem ersten Kühlkörperteil (7) umfasst, wobei bei einem Lösen des zweiten Kühlkörperteils (9) vom ersten Kühlkörperteil (7) das erste Kühlkörperteil (7) mit dem elektronischen Bauelement (3) verbunden bleibt.

8. Rack zur Aufnahme mehrerer Elektronikkomponenten, wie Server für Datenverarbeitungsanlagen,
a) wobei auf mehreren Elektronikkomponenten (27) wenigstens ein zu kühlendes elektronisches Bauelement (3) angeordnet ist,
**dadurch gekennzeichnet,**
b) **dass** die zu kühlenden elektronischen Bauelemente (3) jeweils mit einer Kühlvorrichtung (1) nach einem der vorhergehenden Ansprüche ausgerüstet sind, welche als mit einem flüssigen Medium durchströmte Kühlvorrichtungen ausgebildet ist.

9. Rack nach Anspruch 8, **dadurch gekennzeichnet, dass** die zweiten Kühlkörperteile (9) der Kühlvorrichtungen (1) mit ihren Zulauf- (23) und Rücklaufanschlüssen (25) mit einem oder mehreren zentralen Kühlmittelreservoires oder einem oder mehreren zentralen Wärmetauschern verbunden sind, über welche dem Kühlmedium Wärme entzogen wird.

10. Rack nach Anspruch 9, **dadurch gekennzeichnet, dass** das eine oder die mehreren zentralen Kühlmittelreservoires oder der eine oder die mehreren zentralen Wärmetauscher im oder am Rack (29) angeordnet sind.

11. Rack nach Anspruch 8, **dadurch gekennzeichnet, dass** im Rack (29) ein Leitungssystem vorgesehen ist, welches die Zulaufanschlüsse (23) der Kühlvorrichtungen (1) mit einem oder mehreren zentralen Zulaufanschlüssen (31) des Racks (29) und die Rücklaufanschlüsse (25) der Kühlvorrichtungen (1) mit einem oder mehreren zentralen Rücklaufanschlüssen (33) des Racks (29) verbindet.

12. Rack nach Anspruch 10 oder 11, **dadurch gekennzeichnet, dass** im Rack (29) wenigstens eine fest im Rack (29) angeordnete, vorzugsweise starre Zulauf-Steigleitung (35) vorgesehen ist, welche mehrere Anschlüsse (39) für vorzugsweise flexible Verbindungsleitungen von jeweils einem Anschluss (39) zu einem Zulaufanschluss (23) eines zweiten Kühlkörperteils (9) einer Kühlvorrichtung (1) aufweist, und dass im Rack (29) wenigstens eine fest im Rack (29) angeordnete, vorzugsweise starre Rücklauf-Steigleitung (37) vorgesehen ist, welche mehrere Anschlüsse (39) für vorzugsweise flexible Verbindungsleitungen von jeweils einem Anschluss (39) zu einem Rücklaufanschluss (25) eines zweiten Kühlkörperteils (9) einer Kühlvorrichtung (1) aufweist.

13. Rack nach Anspruch 11 oder 12, **dadurch gekennzeichnet, dass** das Leitungssystem eine Zulaufsteigleitung und eine Rücklaufsteigleitung sowie eine mit der Rücklaufsteigleitung verbundene Abführleitung umfasst, wobei die Durchströmungslängen aller angeschlossenen Kühlvorrichtungen zumindest annähernd gleich sind, wobei sich die Durchströmungslängen aus den Teillängen der jeweils von der betreffenden Teilströmung der jeweiligen Kühlvorrichtung genutzten Längen der Zulaufsteigleitung und der Rücklaufsteigleitung ergeben.

## Claims

1. Cooling device for an electronic component, especially a micro processor, comprising
a) a heat sink (7, 9) through which a liquid coolant is flowable, which is connectable to the electronic component (3) to be cooled such that the waste heat, which is produced by the electronic component (3) is transferred via a thermical interface of the electronic component to the heat sink (7,9) and is transported away,
b) wherein the heat sink (7, 9) comprises a first heat sink part (7), which is formed for connecting to the electronic component (3) or is connected with it,
c) wherein the heat sink (7, 9) comprises a second heat sink part (9) which has at least one channel (15), through which a liquid coolant is flowable,
d) wherein a supply connection (9) and a return connection (25) are provided at the second heat sink part (9) which are connected to the at least one channel (15),
e) wherein the second heat sink part (9) is detachably connected with the first heat sink part (7) such that there is a low resistant to heat transfer is given, wherein at least a predominant portion of the waste heat is transferred via the second heat sink part (9) to the liquid coolant and
f) wherein the second heat sink part (9) is detachable from the first heat sink part (7) without having to detach the connection between the first heat sink part (7) with the electronic component (3)
g) wherein the first heat sink part (7) comprises a contact surface for thermal connection to the second heat sink part (9) which has a structure (11) for increasing the contact surface, wherein the contact surface of the first heat sink part (7) interacts with a complementary contact surface of the second heat sink part (9), and
h) wherein the structures are formed as rips (11, 13) with bevelled sides
**characterized in that**,
i) that at least in the rips (13) of the second heat sink part (9) said at least one channel (15) for the liquid coolant is provided.

2. Cooling device according to claim 1,
**characterized in that**,
the edges are formed flat and preferably have a trapezoidal cross-section.

3. Cooling device according to one of the preceding claims,
**characterized in that**,
in the region of the supply connection (23) and/or the return connection (25) the second heat sink part (9) has a collection chamber, from which several channels (15) for the coolant branch out of or open into this chamber.

4. Cooling device according to one of the preceding claims,
**characterized in that**,
the second heat sink part (9) has greater dimensions than the first heat sink part (7) at least in one direction relative to the contact surface with the first heat sink part (7) and **in that** the second heat sink part (9) is formed so that an essentially uniform heat transfer is possible with reference to the contact surface by means of the coolant flow through the one or more channels (15) in the contact surface with the first heat sink part (7).

5. Cooling device according to one of the preceding claims,
**characterized in that**,
the first heat sink part (7) is formed as a heat pipe.

6. Cooling device according to one of the preceding claims,
**characterized in that**,
an attachment device is provided, which comprises means for preferably detachable connection of the first heat sink part (7) to the electronic component (3) to be cooled.

7. Cooling device according to claim 6,
**characterized in that**,
the attachment device comprises additional means for detachable connection of the second heat sink part (9) to the first heat sink part (7), wherein when the second heat sink part (9) is detached from the first heat sink part (7), the first heat sink part (7) remains connected to the electronic component (3).

8. Rack for storing several electronic components, such as servers for data-processing systems,
a) wherein at least one electronic component (3) to be cooled is arranged on several electronic components (27),
**characterized in that**,
b) the electronic components (3) to be cooled are each equipped with a cooling device (1) according to one of the preceding claims, which is formed as a cooling device carrying a flow of liquid medium.

9. Rack according to claim 8,
**characterized in that**,
the second heat sink part (9) of the cooling devices (1) are connected with their supply (23) and return connection (25) to one or more central coolant reservoirs or one or more central heat exchangers, by means of which heat is drawn away from the coolant.

10. Rack according to claim 9,
**characterized in that**,
the one or more central coolant reservoirs or the one or more central heat exchangers are arranged in or on the rack (29).

11. Rack according to claim 8,
**characterized in that**,
in the rack (29) there is a line system, which connects the supply connection (23) of the cooling devices (1) to one or more central supply connections (31) of the rack (29) and the returned connection (25) of the cooling devices (1) to one or more central returned connections (33) of the rack (29).

12. Rack according to claim 10 or 11,
**characterized in that**,
in the rack (29) there is at least one preferably rigid supply riser (35), which is arranged fixed in the rack (29) and which has several connections (39) for preferably flexible connection lines each from a connection (39) to a supply connection (23) of a second heat sink part (9) of a cooling device (1), and **in that** in the rack (29) there is at least one preferably rigid return riser (37), which is arranged fixed in the rack (29) and which has several connections (39) for preferably flexible connection lines each from a connection (39) to a return connection (25) of a second heat sink part (9) of a cooling device (1).

13. Rack according to claim 11 or 12,
wherein in that,
the line system comprises a supply riser and a return riser, and also an outlet line connected to the return riser, wherein the flow lengths of all of the connected cooling devices are at least approximately equal, wherein the flow lengths are given from the partial lengths of the supply riser and the return riser used by the affected partial flow of the corresponding cooling device.

## Revendications

1. Dispositif de refroidissement pour un composant électronique, en particulier un microprocesseur,
a) avec un corps réfrigérant (7, 9) pouvant être traversé par un agent réfrigérant, corps qui peut être relié de telle façon au composant électronique (3) à refroidir que la chaleur perdue par l'élément électronique (3) soit transférée par une interface thermique du composant électronique vers le corps réfrigérant (7, 9) et évacuée,
b) dans lequel le corps réfrigérant (7, 9) comprend une première partie (7) de corps réfrigérant qui est conformée pour être reliée au composant électronique (3) ou qui est reliée à celui-ci,
c) dans lequel le corps réfrigérant (7, 9) comprend une deuxième partie (9) de corps réfrigérant qui comprend au moins un canal (15) pouvant être traversé par l'agent réfrigérant liquide,
d) dans lequel il est prévu sur la deuxième partie (9) de corps réfrigérant un raccord d'alimentation (23) et un raccord de retour (25) qui sont reliés audit au moins un canal (15),
e) dans lequel la deuxième partie (9) de corps réfrigérant est reliée de telle façon à la première partie (7) de corps réfrigérant qu'une faible résistance au transfert thermique soit présente, au moins la majeure partie de la chaleur perdue étant délivrée à l'agent réfrigérant par l'intermédiaire de la deuxième partie (9) de corps réfrigérant, et
f) dans lequel la deuxième partie (9) de corps réfrigérant peut être détachée de la première partie (7) de corps réfrigérant sans devoir détacher la liaison de la première partie (7) de corps réfrigérant avec le composant électronique (3),
g) dans lequel la première partie (7) de corps réfrigérant comprend une surface de contact pour la liaison thermique avec la deuxième partie (9) de corps réfrigérant, qui comprend une structure destinée à agrandir la surface de contact, la surface de contact de la première partie (7) de corps réfrigérant coopérant avec une surface de contact de forme complémentaire de la deuxième partie (9) de corps réfrigérant, et
h) dans lequel les structures sont conformées en nervures (11, 13) à flancs obliques,
***caractérisé en ce que***
i) au moins dans les nervures (13) de la deuxième partie (9) de corps réfrigérant est prévu ledit au moins un canal (15) pour l'agent réfrigérant.

2. Dispositif de refroidissement selon la revendication 1, ***caractérisé en ce que*** les flancs sont plats et réalisés de préférence avec une section trapézoïdale.

3. Dispositif de refroidissement selon l'une quelconque des revendications précédentes, ***caractérisé en ce que*** la deuxième partie (9) de corps réfrigérant comprend au niveau du raccord d'alimentation (23) et/ou du raccord de retour (25) une chambre de collecte dont partent ou arrivent plusieurs canaux (15) pour l'agent réfrigérant.

4. Dispositif de refroidissement selon l'une quelconque des revendications précédentes, ***caractérisé en ce que*** la deuxième partie (9) de corps réfrigérant présente au moins dans une direction, par rapport à la surface de contact avec la première partie (7) de corps réfrigérant, des dimensions plus grandes que la première partie (7) de corps réfrigérant et ***en ce que*** la deuxième partie (9) de corps réfrigérant est conformée de telle façon qu'au moyen de l'écoulement d'agent réfrigérant à travers ledit au moins un canal (15), une évacuation de chaleur sensiblement régulière sur la surface de contact soit possible au niveau de la surface de contact avec la première partie de corps réfrigérant.

5. Dispositif de refroidissement selon l'une quelconque des revendications précédentes, ***caractérisé en ce que*** la première partie (7) de corps réfrigérant est conformée en caloduc.

6. Dispositif de refroidissement selon l'une quelconque des revendications précédentes, ***caractérisé en ce* qu'**un dispositif de fixation est prévu, qui comprend des moyens pour relier, de préférence de façon amovible, la première partie (7) de corps réfrigérant au composant électronique (3) à refroidir.

7. Dispositif de refroidissement selon la revendication 6, ***caractérisé en ce que*** le dispositif de fixation comprend d'autres moyens pour relier de manière amovible la deuxième partie (9) de corps réfrigérant à la première partie (7) de corps réfrigérant, la première partie (7) de corps réfrigérant restant reliée au composant électronique (3) en cas de libération de la deuxième partie (9) de corps réfrigérant d'avec la première partie (7) de corps réfrigérant.

8. Bâti destiné à recevoir plusieurs pièces électroniques, telles que des serveurs pour des systèmes de traitement de données,
a) dans lequel au moins un composant électronique (3) à refroidir est placé sur plusieurs pièces électroniques (27),
***caractérisé en ce que***
b) les composants électroniques (3) à refroidir sont équipés chacun d'un dispositif de refroidissement (1) selon l'une quelconque des revendications précédentes, qui sont conformés en dispositifs de refroidissement traversés par un agent liquide.

9. Bâti selon la revendication 8, ***caractérisé* en *ce que*** les deuxièmes parties (9) de corps réfrigérant des dispositifs de refroidissement (1) sont reliées par leurs raccords d'alimentation (23) et de retour (25) à un ou plusieurs réservoirs centraux d'agent réfrigérant ou un ou plusieurs échangeurs de chaleur centraux, par l'intermédiaire desquels de la chaleur est extraite de l'agent réfrigérant.

10. Bâti selon la revendication 9, ***caractérisé en ce que*** le ou les plusieurs réservoirs centraux d'agent réfrigérant, ou le ou les plusieurs échangeurs de chaleur centraux sont placés dans ou sur le bâti (29).

11. Bâti selon la revendication 8, ***caractérisé en ce qu'**il* est prévu dans le bâti (29) un système de conduites qui relie les raccords d'alimentation (23) des dispositifs de refroidissement (1) à un ou plusieurs raccords d'alimentation centraux (31) du bâti (29) et les raccords de retour (25) des dispositifs de refroidissement (1) à un ou plusieurs raccords de retour centraux (33) du bâti (29).

12. Bâti selon la revendication 10 ou 11, ***caractérisé en* ce *que*** dans le bâti (29) est prévue une conduite montante d'alimentation (35) de préférence rigide, placée de manière fixe dans le bâti (29), qui comprend plusieurs raccords (39) pour des conduites de jonction de préférence flexibles entre, à chaque fois, un raccord (39) et un raccord d'alimentation (23) d'une deuxième partie (9) de corps réfrigérant d'un dispositif de refroidissement (1), et **en *ce que*** dans le bâti (29) est prévue une conduite montante de retour (37) de préférence rigide, placée de manière fixe dans le bâti (29), qui comprend plusieurs raccords (39) pour des conduites de jonction de préférence flexibles entre, à chaque fois, un raccord (39) et un raccord de retour (25) d'une deuxième partie (9) de corps réfrigérant d'un dispositif de refroidissement (1).

13. Bâti selon la revendication 11 ou 12, ***caractérisé en ce que*** le système de conduites comprend une conduite montante d'alimentation et une conduite montante de retour, ainsi qu'une conduite d'évacuation reliée à la conduite montante de retour, les longueurs d'écoulement de tous les dispositifs de refroidissement raccordés étant au moins approximativement égales, les longueurs d'écoulement étant données par les sous-longueurs de la colonne montante d'alimentation et de la colonne montante de retour utilisées chacune pour l'écoulement correspondant du dispositif de refroidissement concerné.
